# EUROPEAN PATENT APPLICATION

(11) **EP 2 579 047 A1**
(43) Date of publication of application: **10.04.2013**
(21) Application number: 11786443.9
(22) Date of filing: 20.04.2011
(51) Int. Cl.: G01R 19/00

(54) **VOLTAGE MEASURING APPARATUS FOR BATTERY PACK**

(30) Priority: 28.05.2010 JP 2010123098
(71) Applicant: Yazaki Corporation, Minato-ku Tokyo 108-8333 (JP)
(72) Inventor: ISHIKAWA Satoshi, Shizuoka 421-0407 (JP); SAIGO Tsutomu, Shizuoka 410-1107 (JP)
(74) Representative: Grünecker, Kinkeldey, Stockmair & Schwanhäusser
(86) International application number: PCT/JP2011/059758
(87) International publication number: WO 2011/148743

(57) **Abstract**

There is provided a voltage measuring apparatus for a battery assembly which can measure output voltages with high precision even when the output voltages of cells are negative. The voltage measuring apparatus includes a polarity detector circuit (50) that is disposed for each of plural cells (P1 to P55), and detects the polarities of the voltages output by the cells, an absolute value circuit (40) that is disposed for each of the plural cells to detect the absolute values of the voltages output by the cells, A/D converters (26) that are each disposed for a respective one of a plurality of blocks (61-1) to (61-5) into which the respective cells are sectioned and which include at least one cell to digitalize the absolute voltages detected by the absolute value circuit (40) in correspondence with the cells of the respective blocks, and a control unit (27) of voltage detection ICs (21-1) to (21-5) that calculate the output voltages with the polarities for each of the cells on the basis of the digitalized absolute voltages and the polarities of the voltages to detect the total voltages of the output voltages with the polarities for each of the blocks.

## Description

### Technical Field

The present invention relates to a voltage measuring apparatus that detects voltages in a battery assembly in which a plurality of cells are connected in series to output a desired voltage.

### Background Art

For example, electric vehicles and hybrid vehicles each have a high voltage battery as a drive power supply of a motor. The high voltage battery of this type connects a plurality of cells of secondary batteries (rechargeable batteries) such as hydrogen batteries or lithium batteries in series to obtain a high voltage.

Also, because all of the secondary batteries are charged or discharged with the same electric power, if the deteriorated states of the respective secondary batteries are different from each other, the secondary batteries are liable to be overcharged or overdischarged. Under the circumstances, there is a need to confirm the charged states of the respective unit cells so that the secondary batteries are not overcharged or overdischarged. For that reason, a plurality (for example, 55) of unit cells is divided into, for example, five blocks (that is, each block having 11 cells), and the voltage of each block is measured by a voltage detection IC provided for each block in real time.

In this situation, the voltage detection IC measures the voltage of the unit cells (for example, 11 cells) in one block, and an A/D converter having an IC for voltage detection converts a detected analog voltage signal into a digital signal, and transmits the digital signal to a main microcomputer. Thereafter, the main microcomputer determines the abnormality of the secondary battery according to whether the measured voltage value falls within a given range, or not (for example, refer to Patent Literature 1).

### Citation List

### Patent Literature

Patent Literature 1: JP-A-2005-62028

### Summary of Invention

### Technical Problem

However, in the above-mentioned conventional voltage measuring apparatus, when both of a positive voltage and a negative voltage are present as an output voltage of the battery, the A/D converter can detect only the positive voltage. Therefore, the voltage detection IC detects the negative output voltage as 0 V, and transmits a signal to the main microcomputer. As a result, the output voltage cannot be measured with precision.

In particular, when the conventional voltage measuring apparatus is applied to a fuel battery vehicle that generates an electric power using hydrogen and oxygen as fuel to allow the vehicle to travel, the output voltage of a fuel battery may become negative according to a state of the fuel within a cell disposed in the fuel battery. In this situation, since the A/D converter cannot A/D convert the negative voltage, the output voltage of the cell is detected as 0 V. As a result, there arises such a problem that the output voltage cannot be measured with precision.

Under the circumstance, the present invention has been made to solve the above conventional problem, and an object of the present invention is to provide a voltage measuring apparatus for a battery assembly which can measure an output voltage with high precision even when the output voltage of the cell is negative.

### Solution to Problem

In order to achieve the above object, according to a first aspect of the present invention, there is provided a voltage measuring apparatus that measures an output voltage in a battery assembly in which a plurality of cells are connected in series to output a desired voltage, which includes polarity detection units that are each provided for a respective one of the plurality of cells to detect polarities of the voltages output from the cells, absolute value detection units that are each provided for a respective one of the plurality of cells to detect absolute values of the voltages output from the cells, A/D conversion units that are each provided for a respective one of a plurality of blocks into which the respective cells are sectioned and which includes at least one cell, to digitalize the absolute values of the voltages detected by the absolute value detection units in correspondence with the cell of the respective blocks, and voltage detection units that calculate the output voltages with the polarities for the respective cells on the basis of the digitalized absolute values of the voltages and the polarities of the voltages to detect the total voltages of the output voltages with the polarities for each of the blocks.

According to a second aspect of the present invention, there is provided the voltage measuring apparatus for a battery assembly according to the first aspect of the invention, further including a control unit that outputs a voltage measurement request signal to the respective voltage detection units, acquires the total voltages detected by the respective voltage detection units, and provides the acquired total voltages as the output voltages of the cells, and a voltage conversion unit that is connected to a power supply which supplies an electric power for operating the control unit to convert the electric power from the power supply, in which the control unit outputs a power supply signal for supplying the electric power to the voltage conversion unit when outputting the voltage measurement request signal to the respective voltage detection units, and the voltage conversion unit supplies the electric power to the absolute value detection units upon acquiring the voltage measurement request signal from the control unit.

According to a third aspect of the present invention, there is provided the voltage measuring apparatus for a battery assembly according to the first or second aspect of the invention, further including a control unit that outputs a voltage measurement request signal to the respective voltage detection units, acquires the total voltages detected by the respective voltage detection units, and provides the acquired total voltages as the output voltages of the cells, and a voltage conversion unit that is connected to a power supply which supplies an electric power for operating the control unit to convert the electric power from the power supply, in which the control unit outputs a power supply signal for supplying the electric power to the voltage conversion unit when outputting the voltage measurement request signal to the respective voltage detection units, and the voltage conversion unit supplies the electric power to the polarity detection units upon acquiring the voltage measurement request signal from the control unit.

According to a fourth aspect of the present invention, there is provided the voltage measuring apparatus for a battery assembly according to any one of the first to third aspects of the invention, in which the cells are N cells, that is, a first cell to an N-th cell, a negative electrode of the first cell is grounded, a positive electrode of the N-th cell is set to the highest voltage, and a voltage of an n-th cell (2≤n≤N) is measured with a voltage of an (n-1)-th cell as a reference voltage.

### Advantageous Effects of Invention

According to the first aspect of the present invention, the absolute values of the voltages output by the cells are detected by the absolute value detection units, and the detected absolute value voltages are subjected to A/D conversion. For that reason, the A/D conversion units do not the negative output voltages to the A/D conversion.

Also, the output voltages with the polarities for the respective cells are calculated by the voltage detection units on the basis of the absolute values of the voltages and the polarities of the voltages, and the total voltages of the output voltages with the polarities are detected. For that reason, the output voltages can be measured with precision.

Accordingly, there can be provided the voltage measuring apparatus for a battery assembly which can measure the output voltages with high precision even when the output voltages of the cells are negative.

Further, because the total of the output voltages is obtained by the polarity detection units and the absolute value detection units in correspondence with the cells in each of the blocks, there is no need to change the configuration of the voltage detection units, and the manufacture costs can be reduced.

According to the second aspect of the present invention, because the electric power is supplied to the absolute value detection units by the voltage conversion unit connected to the power supply which supplies the electric power for operating the control unit, there is no need to provide an additional power supply, and the manufacture costs can be reduced.

According to the third aspect of the present invention, because the electric power is supplied to the polarity detection units by the voltage conversion unit connected to the power supply which supplies the electric power for operating the control unit, there is no need to provide an additional power supply, and the manufacture costs can be reduced.

According to the fourth aspect of the present invention, because the voltage of n-th cell is measured with the voltage of the (n-1)-th cell as the reference voltage, an error in the measured values can be always reduced by measuring the positive absolute voltages as the reference voltage.

### Brief Description of Drawings

[FIG. 1] FIG. 1 is a block diagram illustrating a configuration of a voltage measuring apparatus for a fuel battery according to an embodiment of the present invention.
[FIG. 2] FIG. 2 is a block diagram illustrating a detailed configuration of the voltage measuring apparatus according to the embodiment of the present invention.
[FIG. 3] FIG. 3 is a diagram illustrating an absolute value circuit in the voltage measuring apparatus according to the embodiment of the present invention.
[FIG. 4] FIG. 4 is a diagram illustrating a reference voltage of the absolute value circuit in the voltage measuring apparatus according to the embodiment of the present invention.
[FIG. 5] FIG. 5 is a flowchart illustrating a voltage measuring process in the voltage measuring apparatus according to the embodiment of the present invention.

### Description of Embodiments

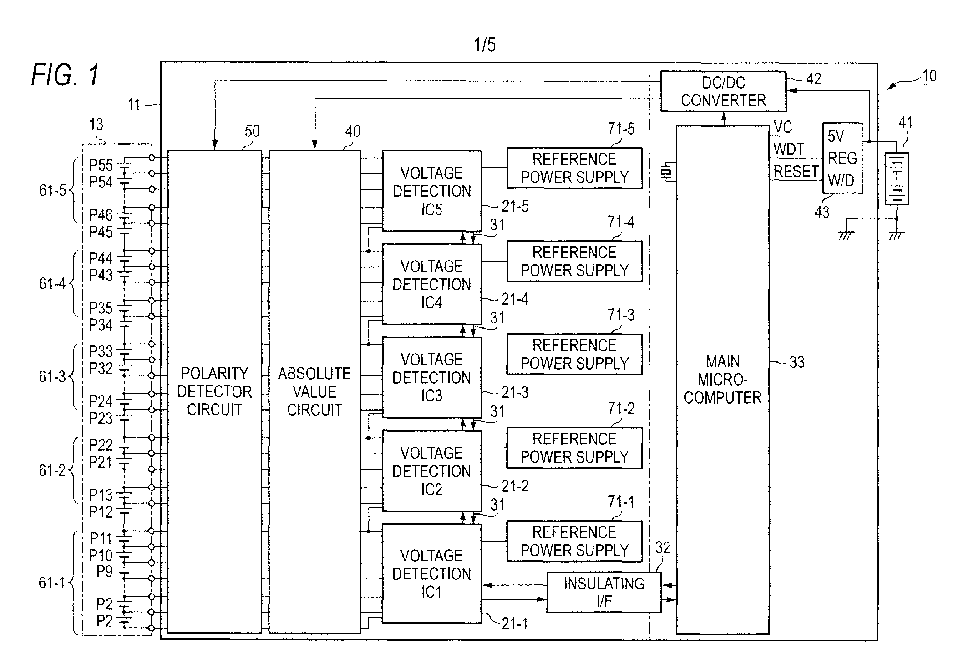

Hereinafter, an embodiment of the present invention will be described with reference to the drawings. First, a voltage measuring apparatus according to the embodiment of the present invention will be described with reference to FIG. 1. FIG. 1 is a block diagram illustrating a voltage measuring apparatus 10 for a fuel battery, and a fuel battery 13 having a plurality of cells P1 to P55 according to the embodiment of the present invention. The fuel battery 13 according to this embodiment is, for example, mounted on a vehicle, and intended to supply an electric power for driving a vehicle driving motor.

As illustrated in FIG. 1, the voltage measuring apparatus 10 according to the embodiment of the present invention measures an output voltage of the fuel battery that connects the plurality of cells P1 to P55 in series and outputs the voltage.

The plurality of cells P1 to P55 includes 55 cells of a first cell to a 55^{th} cell. A negative electrode of the cell P1 (first cell) is grounded, and a positive electrode of the cell P55 (55^{th} cell) has the highest voltage. The plurality of cells P1 to P55 is each provided with a polarity detector circuit (polarity detection unit) 50.

Also, the plurality of cells P1 to P55 is each provided with an absolute value circuit (absolute value detection unit) 40. The absolute value circuit 40 detects an absolute value of the voltage output by each of the plurality of cells P1 to P55. For example, when the voltage output by the cell P1 is -2.5V, the absolute value circuit 40 detects the absolute voltage of P1 as 2.5V.

Also, as illustrated in FIG. 1, the voltage measuring apparatus 10 according to the embodiment of the present invention is divided into a high-voltage side device 11 and a low-voltage side device 12 through an insulating interface 32.

The high-voltage side device 11 includes five voltage detection ICs (voltage detection units), that is, a first voltage detection IC (21-1) to a fifth voltage detection IC (21-5). The first voltage detection IC (21-1) detects polarity signals detected by the polarity detector circuit 50 in correspondence with 11 cells P1 to P11 sectioned as a first block (61-1), and measures the absolute value voltages which are the output voltages of the absolute value circuit 40 in correspondence with the cells P1 to P11.

Also, the second voltage detection IC (21-2) detects the polarity signals detected by the polarity detector circuit 50 in correspondence with 11 cells P12 to P22 sectioned as a second block (61-2), and measures the absolute voltages which are the output voltages of the absolute value circuit 40 in correspondence with the cells P12 to P22. Likewise, the third voltage detection IC (21-3) detects the polarity signals detected by the polarity detector circuit 50 in correspondence with 11 cells P23 to P33 sectioned as a third block (61-3), and measures the absolute voltages which are the output voltages of the absolute value circuit 40 in correspondence with the cells P23 to P33. The fourth voltage detection IC (21-4) detects the polarity signals detected by the polarity detector circuit 50 in correspondence with 11 cells P34 to P44 sectioned as a fourth block (61-4), and measures the absolute voltages which are the output voltages of the absolute value circuit 40 in correspondence with the cells P34 to P44. The fifth voltage detection IC (21-5) detects the polarity signals detected by the polarity detector circuit 50 in correspondence with 11 cells P45 to P55 sectioned as a fifth block (61-5), and measures the absolute voltages which are the output voltages of the absolute value circuit 40 in correspondence with the cells P45 to P55.

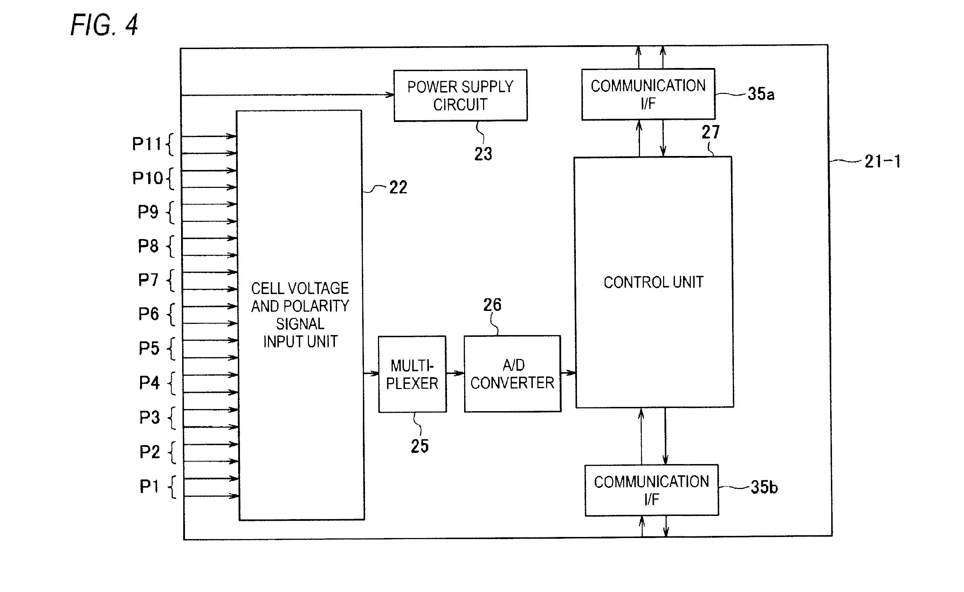

Further, each of the voltage detection ICs (21-1) to (21-5) is provided with an A/D converter 26 (refer to FIG. 4 to be described later, called "ADC"). The A/D converter 26 converts analog voltage signals (voltage signals of 11 cells connected in series) of the polarity signals detected for each block (first block to fifth block) into digital voltage signals, on the basis of reference voltages output from A/D conversion reference power supplies 71-1 to 71-5 (refer to FIG. 1).

Also, the A/D converter 26 converts the analog voltage signals (voltage signals of 11 cells connected in series) of the absolute voltages measured for each block into digital voltage signals. That is, the absolute value circuit 40 outputs the absolute values obtained by removing the polarity (positive or negative sign) from the voltages output by the plurality of cells P1 to P55, and therefore the analog voltage signals to be input to the A/D converter 26 are always the analog voltage signals of the positive voltage.

Also, the second to fifth voltage detection ICs (21-2) to (21-5) are connected to the first voltage detection IC (21-1) through a communication line 31, and the first voltage detection IC (21-1) is connected to a main microcomputer (control unit) 33 disposed on the low-voltage side device 12 side through the insulating interface 32. That is, the main microcomputer 33 and the respective voltage detection ICs (21-1) to (21-5) are connected to each other through the insulating interface 32 by a daisy chain communication.

The low-voltage side device 12 is provided with a regulator 43 that outputs a DC voltage of 5 V. The regulator 43 generates the stable DC voltage of 5V from a voltage (for example, 12 V) output from a battery (power supply) 41 mounted in the vehicle, and applies the generated DC voltage to the main microcomputer 33.

Further, the battery 41 is connected to a DC/DC converter (voltage conversion unit) 42, and the DC/DC converter 42 steps up the voltage (for example, 12V) output from the battery 41, and applies an electric power to the polarity detector circuit 50 and the absolute value circuit 40.

In the voltage measuring apparatus 10 according to the embodiment of the present invention, when the main microcomputer 33 outputs a voltage measurement request signal to the respective voltage detection ICs (21-1) to (21-5), the main microcomputer 33 outputs a signal for supplying the electric power to the DC/DC converter 42. When the DC/DC converter 42 acquires the voltage measurement request signal from the main microcomputer 33, the DC/DC converter 42 supplies the electric power to the polarity detector circuit 50 and the absolute value circuit 40.

Then, when the respective voltage detection ICs (21-1) to (21-5) receive the voltage measurement request signal output from the main microcomputer 33, the voltage detection ICs (21-1) to (21-5) calculate the output voltages with the polarities for each of the cells P1 to P55 on the basis of the absolute voltages digitalized by the A/D converter 26 and the polarities of the voltages detected by the polarity detector circuit 50. Then, the voltage detection ICs (21-1) to (21-5) detect a total voltage of the output voltages with the polarities, and transmit the detected total voltage to the main microcomputer 33. The detail will be described later.

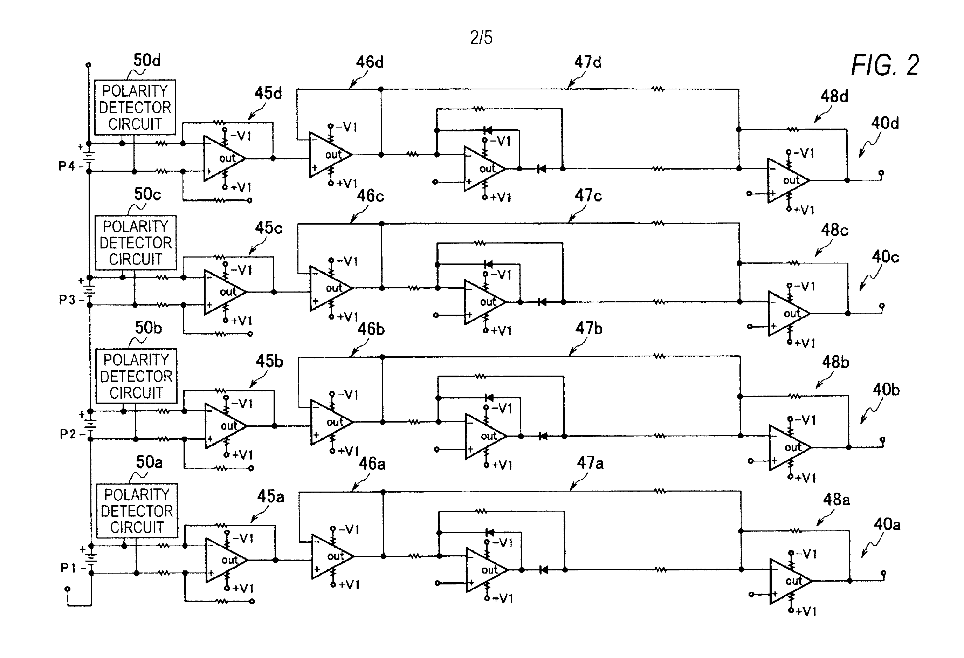

Subsequently, a description will be given in detail of the polarity detector circuit 50 and the absolute value circuit 40 according to the embodiment of the present invention with reference to FIG. 2. FIG. 2 is a circuit diagram of the polarity detector circuit 50 and the absolute value circuit 40 disposed in the cells P1 to P4. Since the cells P5 to P55 have the same circuit configuration as that in the cells P1 to P4, the detailed description thereof will be omitted.

As illustrated in FIG. 2, the cells P1 to P4 are equipped with polarity detector circuits 50a to 50d that detect the polarities of the voltages output by the cells P1 to P4, and absolute value circuits 40a to 40d that detect the absolute values of the voltages output by the cells P1 to P4, and output the absolute values to the first voltage detection IC (21-1) illustrated in FIG. 1, respectively.

The polarity detector circuits 50a to 50d detect the polarity, that is, whether the output voltages output by the cells P1 to P4 are the positive voltage or the negative voltage. Specifically, the voltage output by each of the cells P1 to P4 is input to an operational amplifier (not shown), and if the polarity signal output from the operational amplifier is a signal H, each of the polarity detector circuits 50a to 50d detects that the voltage output by each cell is the positive voltage. If the polarity signal is a signal L, each of the polarity detector circuits 50a to 50d detects that the voltage output by each cell is the negative voltage. The detected polarity signals are output to the first voltage detection IC (21-1) illustrated in FIG. 1.

The electric power is supplied to the operational amplifiers (not shown) of the polarity detector circuits 50a to 50d from the DC/DC converter 42 (refer to FIG. 1). When the polarity detector circuits 50a to 50d receive the electric power from the DC/DC converter 42, the polarity detector circuits 50a to 50d detect whether the polarities of the output voltages of the cells P1 to P4 are the positive voltage or the negative voltage, respectively.

The absolute value circuits 40a to 40d include first inverting amplifier circuits 45a to 45d that amplify and output voltages between positive terminals and negative terminals of the cells P1 to P4, and second inverting amplifier circuits 46a to 46d that receive output voltages of the first inverting amplifier circuits 45a to 45d from positive electrode side, respectively. The absolute value circuits 40a to 40d also include diodes 47a to 47d that turn on when the input voltage is positive, and turn off when the input voltage is negative, which are disposed on the output side of the second inverting amplifier circuits 46a to 46d, and summing amplifier circuits 48a to 48d that are disposed on the output side of the diodes 47a to 47d.

The electric power is supplied from the DC/DC converter 42 to power supplies +V1 and -V1 of operational amplifiers provided in the first inverting amplifier circuits 45a to 45d, the second inverting amplifier circuits 46a to 46d, the diodes 47a to 47d, and the summing amplifier circuits 48a to 48d. When the electric power is supplied from the DC/DC converter 42 to the absolute value circuits 40a to 40d, the absolute value circuits 40a to 40d output the absolute voltages of the output voltages of the cells P1 to P4 to the first voltage detection IC (21-1) illustrated in FIG. 1. For example, if the output voltage of the cell P1 is 2.5V, the absolute voltage is output as 2.5 V, and if the output voltage of the cell P2 is -2.5V, the absolute voltage is output as 2.5 V.

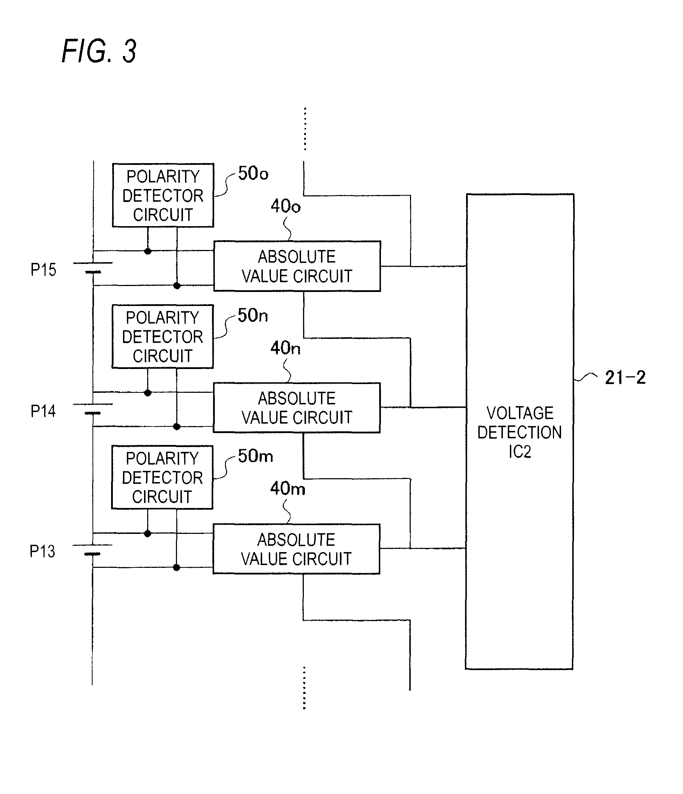

Subsequently, a description will be given of the reference voltage of the absolute value circuit 40 according to the embodiment of the present invention with reference to FIG. 3. FIG. 3 is a diagram illustrating the reference voltage of the absolute value circuit 40 according to the embodiment of the present invention. The cells P2 to P55 have the same configuration as that of the cells P13 to P15, and therefore the detailed description thereof will be omitted.

As illustrated in FIG. 3, the cells P13 to P15 are provided with polarity detector circuits 50m to 50o that detect the polarities of the voltages output by the cells P13 to P15, respectively. Also, the voltage output from the absolute value circuit 40 of an n-th cell (2≤n≤N) is measured with a voltage of a (n-1)-th cell as a reference voltage. That is, the cell P14 (14^{th} cell) measures the output voltage of the cell P14 with the absolute voltage output from the absolute value circuit 40m of the cell P13 (13^{th} cell) as the reference voltage.

Also, the cell P15 (15^{th} cell) measures the output voltage of the cell P15 with the absolute voltage output from the absolute value circuit 40n of the cell P14 (14^{th} cell) as the reference voltage. The cell P1 (first cell) (refer to FIG. 1) measures the output voltage of P1 with the ground as the reference voltage.

Subsequently, a description will be given of the detailed configuration of the voltage detection IC according to the embodiment of the present invention with reference to FIG. 4. FIG. 4 is a block diagram illustrating an internal configuration of the first voltage detection IC (21-1). The second to fifth voltage detection IC (21-2) to (21-5) have the same configuration as that of the first voltage detection IC (21-1), and therefore the detailed description thereof will be omitted.

As illustrated in FIG. 4, the first voltage detection IC (21-1) includes a power supply circuit 23 that receives the electric powers output from the cells P1 to P11 to generate a given voltage, and a cell voltage and polarity signal input unit 22 that detects the polarity signals detected by the polarity detector circuit 50 provided for each of the respective cells P1 to P11 provided in the first block (61-1), and the absolute voltages output from the absolute value circuit 40 provided for each of the cells P1 to P11. The first voltage detection IC (21-1) also includes a multiplexer 25 that converts the signals of the respective cells, which are output from the cell voltage and polarity signal input unit 22, into time-series signals of one system, and an A/D converter 26 that converts the signals of the respective unit cells, which are output from the multiplexer 25, into digital signals.

The A/D converter 26 converts the polarity signals and the absolute voltage signals of the respective cells, which are output from the multiplexer 25, into the digital signals on the basis of the reference voltage output from the reference power supply 71-1 (refer to FIG. 1). Also, the first voltage detection IC (21-1) includes a control unit 27, and two communication I/Fs 35a and 35b.

The control unit 27 controls the first voltage detection IC (21-1) as a whole. In particular, when the voltage measurement request signal of the cell voltage is transmitted from the main microcomputer 33 illustrated in FIG. 1, the control unit 27 obtains a total voltage according to the polarity signals detected by the polarity detector circuit 50 provided for each of the cells P1 to P11 and the digital voltages resulting from digitalizing the output voltages of the absolute value circuit 40 by the A/D converter 26, and transmits the total voltage to the main microcomputer 33 through the communication I/Fs 35a and 35b.

Also, in the case of obtaining the total voltage, the control unit 27 adds the absolute voltages corresponding to the cells whose polarity signals are positive, and subtracts the absolute voltages corresponding to the cells whose polarity signals are negative to obtain the total voltage. That is, the signals of the respective cells, which are output from the cell voltage and polarity signal input unit 2, are converted into the time-series signals of one system and input to the control unit 27. As a result, for example, if a first input polarity signal is positive, and a second input polarity signal is negative, the control unit 27 adds the first input absolute voltage (for example, 2.5 V), and subtracts the second input absolute voltage (for example, 0.5 V), to thereby obtain the total voltage (for example, 2.0 V).

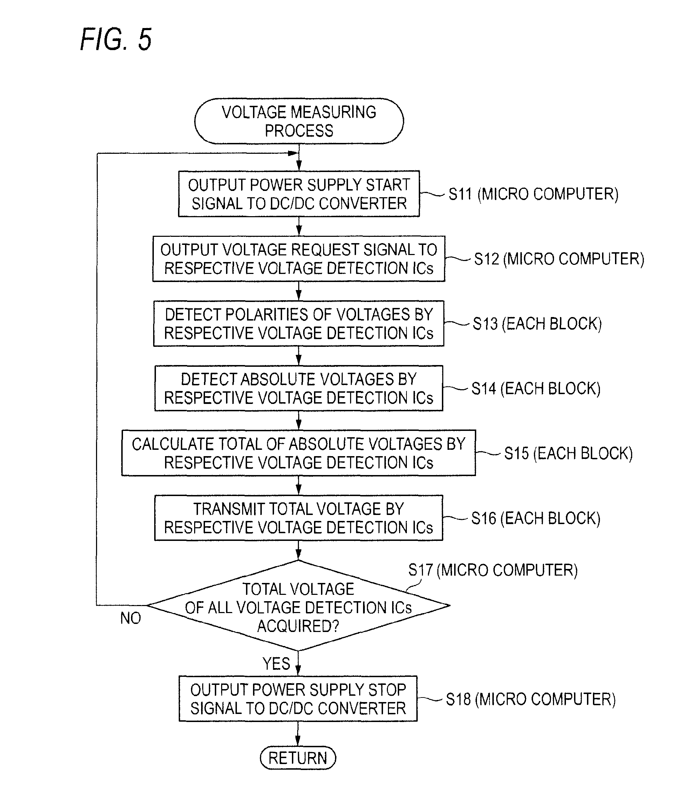

Subsequently, a description will be given of the operation of the voltage measuring apparatus 10 configured as described above, according to the embodiment of the present invention. FIG. 5 is a flowchart of a voltage measuring process according to the embodiment of the present invention.

First, in processing of Step S11, the main microcomputer 33 outputs a power supply signal for instructing the DC/DC converter 42 to start the power supply. As a result, the output voltage (for example, 12 V) of the battery 41 is stepped up to a high voltage of about 40 V, and then applied to the polarity detector circuit 50 and the absolute value circuit 40.

In processing of Step S12, the main microcomputer 33 measures the output voltages of the cells P1 to P55 in the respective blocks on the basis of the signals output to the respective voltage detection ICs (21-1) to (21-5) from the polarity detector circuit 50 and the absolute value circuit 40, and outputs the voltage measurement request signal for instructing the respective voltage detection ICs (21-1) to (21-5) to detect the total voltage obtained by summing up the measured voltages.

In processing of Step S13, upon receiving the instructions from the main microcomputer 33, the voltage detection ICs (21-1) to (21-5) detect the polarities of the voltages output from the polarity detector circuit 50 in correspondence with the cells P1 to P55 in the respective blocks. In this processing, the polarity signals detected by the polarity detector circuit 50 in correspondence with the respective cells P1 to P55 are supplied to the cell voltage and polarity signal input unit 22, and further supplied to the A/D converter 26 through the multiplexer 25. As a result, the digitalized polarity signals are input to the control unit 27.

In processing of Step S14, upon receiving the instructions from the main microcomputer 33, the respective voltage detection ICs (21-1) to (21-5) detect the absolute voltages of the voltages output by the cells P1 to P55 by the absolute value circuit 40 in correspondence with the cells P1 to P55 in the respective blocks. In this processing, the absolute voltage signals output by the absolute value circuit 40 in correspondence with the respective cells P1 to P55 are supplied to the cell voltage and polarity signal input unit 22, and further supplied to the A/D converter 26 through the multiplexer 25. As a result, the digitalized absolute voltage signals are input to the control unit 27.

In processing of Step S15, upon receiving the instructions from the main microcomputer 33, the voltage detection ICs (21-1) to (21-5) calculate the voltage value obtained by summing up the absolute voltage data on the basis of the polarity signals input to the control unit 27. That is, in the case of the first voltage detection IC (21-1), the first voltage detection IC (21-1) adds the absolute voltages corresponding to the cells whose polarity signals are positive, and subtracts the absolute voltages corresponding to the cells whose polarity signals are negative, to thereby sum up the 11 absolute voltages which are the output voltages of the cells P1 to P11.

In processing of Step S16, upon receiving the instructions from the main microcomputer 33, the voltage detection ICs (21-1) to (21-5) transmit the total voltage signals of the respective cells P1 to P55, which are calculated in the control unit 27, to the main microcomputer 33 through the communication I/Fs 35a and 35b.

In processing of Step S17, it is determined whether the total voltages have been received from all of the respective voltage detection ICs (21-1) to (21-5), or not. If the main microcomputer 33 determines that the total voltages have not been received from all of the voltage detection ICs (21-1) to (21-5) (no in Step S17), the main microcomputer 33 returns to the processing of Step S11, and transmits the voltage measurement request signal for giving an instruction on the detection of the total voltages to some of the voltage detection ICs (21-1) to (21-5) which do not transmit the total voltages.

On the other hand, if the main microcomputer 33 determines that the total voltages have been received from all of the voltage detection ICs (21-1) to (21-5) (yes in Step S17), the main microcomputer 33 outputs a power supply stop signal for giving an instruction on the stop of the power supply to the DC/DC converter 42 in processing of Step S18. The DC/DC converter 42 that has acquired the power supply stop signal stops the supply of an electric power to the polarity detector circuit 50 and the absolute value circuit 40.

Then, unless the total voltages fall within a given range, the main microcomputer 33 determines that some abnormality occurs in the fuel battery, and outputs an alarm signal. The alarm signal is transmitted to a host system (not shown) of the voltage measuring apparatus 10, and informs a passenger of the vehicle that an abnormality occurs. When this processing is completed, the voltage measuring process is completed.

As described above, the voltage measuring apparatus 10 according to the embodiment of the present invention includes the polarity detector circuit 50 that are each disposed for a respective one of the plurality of cells P1 to P55, and detect the polarities of the voltages output by the cells P1 to P55, the absolute value circuits 40 that are each disposed for a respective one of the plurality of cells P1 to P55 to detect the absolute values of the voltages output by the cells P1 to P55, the A/D converters 26 that are each disposed for a respective one of a plurality of blocks (61-1) to (61-5) into which the respective cells P1 to P55 are sectioned and which include at least one cell to digitalize the absolute voltages detected by the absolute value circuit 40 in correspondence with the cells of the respective blocks (61-1) to (61-5), voltage detection ICs (21-1) to (21-5) and the control unit 27 that calculate the output voltages with the polarities for each of the cells P1 to P55 on the basis of the digitalized absolute voltages and the polarities of the voltages to detect the total voltages of the output voltages with the polarities for each of the blocks (61-1) to (61-5).

Also, the voltage measuring apparatus 10 according to the embodiment of the present invention includes the main microcomputer 33 that outputs the voltage measurement request signal to the respective voltage detection ICs (21-1) to (21-5), acquires the total voltages detected by the respective voltage detection ICs (21-1) to (21-5), and provides the acquired total voltages as the output voltages of the cells P1 to P55, and the DC/DC converter 42 that is connected to the battery 41 which supplies the electric power for operating the main microcomputer 33 to convert the electric power from the battery 41. The main microcomputer 33 outputs the power supply signal for supplying the electric power to the DC/DC converter 42 when outputting the voltage measurement request signal to the respective voltage detection ICs (21-1) to (21-5), and the DC/DC converter 42 supplies the electric power to the absolute value circuits 40 upon acquiring the voltage measurement request signal from the main microcomputer 33.

Further, the voltage measuring apparatus 10 according to the embodiment of the present invention includes the main microcomputer 33 that outputs the voltage measurement request signal to the respective voltage detection ICs (21-1) to (21-5), acquires the total voltages detected by the respective voltage detection ICs (21-1) to (21-5), and provides the acquired total voltages as the output voltages of the cells P1 to P55, and the DC/DC converter 42 that is connected to the battery 41 which supplies the electric power for operating the main microcomputer 33 to convert the electric power from the battery 41. The main microcomputer 33 outputs the power supply signal for supplying the electric power to the DC/DC converter 42 when outputting the voltage measurement request signal to the respective voltage detection ICs (21-1) to (21-5), and the DC/DC converter 42 supplies the electric power to the polarity detector circuit 50 upon acquiring the voltage measurement request signal from the main microcomputer 33.

In the voltage measuring apparatus 10 according to the embodiment of the present invention, the cells P1 to P55 are N (55) cells, that is, a first cell (P1) to an N-th cell (P55), a negative electrode of the first cell (P1) is grounded, a positive electrode of the N-th cell (P55) is set to the highest voltage, and a voltage of an n-th cell (2≤n≤N) is measured with a voltage of an (n-1)-th cell as a reference voltage.

In the voltage measuring apparatus 10 according to the embodiment of the present invention, the absolute values of the voltages output by the cells P1 to P55 are detected by the absolute value circuits 40, and the detected absolute value voltages are subjected to A/D conversion. For that reason, the A/D converters 26 do not subject the negative output voltages to the A/D conversion.

Also, the output voltages with the polarities for the respective cells P1 to P55 are calculated by the control units 27 of the respective voltage detection ICs (21-1) to (21-5) on the basis of the absolute voltages and the polarities of the voltages, and the total voltages of the output voltages with the polarities are detected. For that reason, the output voltages can be measured with precision.

Accordingly, there can be provided the voltage measuring apparatus for a battery assembly which can measure the output voltages with high precision even when the output voltages of the cells are negative.

Further, because the total of the output voltages is obtained by the polarity detector circuits 50 and the absolute value circuit 40 in correspondence with the cells P1 to P55 in the respective blocks (61-1) to (61-5), there is no need to change the configuration of the voltage detection ICs (21-1) to (21-5), and the manufacture costs can be reduced.

Also, because the electric power is supplied to the absolute value circuits 40 by the DC/DC converter 42 connected to the battery 41 which supplies the electric power for operating the main microcomputer 33, there is no need to provide an additional power supply, and the manufacture costs can be reduced.

Further, because the electric power is supplied to the polarity detector circuits 50 by the DC/DC converter 42 connected to the battery 41 which supplies the electric power for operating the main microcomputer 33, there is no need to provide an additional power supply, and the manufacture costs can be reduced.

Also, because the voltage of n-th cell (for example, 14^{th} cell) is measured with the voltage of the (n-1)-th cell (for example, 13^{th} cell) as the reference voltage, an error in the measured values can be reduced by measuring always the positive absolute voltages as the reference voltage.

The voltage measuring apparatus for a fuel battery according to the present invention has been described above on the basis of the embodiment illustrated in the figures. However, the present invention is not limited to this embodiment, and the configurations of the respective parts can be replaced with arbitrary configurations having the same functions.

For example, in the above-mentioned embodiment, a case in which the electric power is supplied to the polarity detector circuit 50 by the DC/DC converter 42 has been described. However, the present invention is not limited to this configuration, but the circuit configuration can be simplified by a configuration in which the electric powers output from the cells P1 to P55 are supplied to the polarity detector circuit 50.

Also, in the above-mentioned embodiment, a case in which the electric power is supplied to the absolute value circuits 40 by the DC/DC converter 42 has been described. However, the present invention is not limited to this configuration, but the circuit configuration can be simplified by a configuration in which the electric powers output from the cells P1 to P55 are supplied to the absolute value circuit 40.

Further, in the above-mentioned embodiment, a case in which the absolute voltages corresponding to the cells whose polarity signals are positive are added, and the absolute voltages corresponding to the cells whose polarity signals are negative are subtracted to obtain the total voltage of the absolute voltages has been described. However, the present invention is not limited to this embodiment, but the total of the absolute voltages corresponding to the positive cells and the absolute voltages corresponding to the cells whose polarity signals are negative may be obtained, and the total voltage may be obtained by subtracting the total of the negative absolute voltages from the total of the positive absolute voltages.

The present invention has been described in detail and with reference to the specific embodiment, but it would be obvious to those skilled in the art that the present invention can be variously changed or modified without departing from the spirit and scope of the present invention.

The present invention is based on Japanese Patent Application No. 2010-123098 filed on May 28, 2010, and the contents of which are incorporated herein by reference.

### Industrial Applicability

The present invention is extremely useful in measuring the output voltages of the fuel battery in which both of the positive voltages and the negative voltages are present.

### Reference Signs List

10 voltage measuring apparatus
11 high-voltage side device
12 low-voltage side device
13 fuel battery
21-1 to 21-5 first to fifth voltage detection ICs
22 cell voltage and polarity signal input unit
23 power supply circuit
25 multiplexer
26 A/D converter
27 control unit
28 communication unit
31 communication line
32 insulating interface
33 main microcomputer
35 communication I/F
40 absolute value circuit
41 battery
42 DC/DC converter
43 regulator
45 first inverting amplifier circuit
46 second inverting amplifier circuit
47 diode
48 summing amplifier circuit
50 polarity detector circuit
61-1 to 61-5 first to fifth blocks
71-1 to 71-5 reference power supplies

## Claims

1. A voltage measuring apparatus that measures an output voltage in a battery assembly in which a plurality of cells are connected in series to output a desired voltage, the voltage measuring apparatus comprising:
polarity detection units that are each provided for a respective one of the plurality of cells to detect polarities of the voltages output from the cells;
absolute value detection units that are each provided for the respective one of the plurality of cells to detect absolute values of the voltages output from the cells;
A/D conversion units that are each provided for a respective one of a plurality of blocks into which the respective cells are sectioned and which includes at least one cell, to digitalize the absolute values of the voltages detected by the absolute value detection units in correspondence with the cell of the respective blocks; and
voltage detection units that calculate the output voltages with the polarities for the respective cells on the basis of the digitalized absolute values of the voltages and the polarities of the voltages to detect the total voltages of the output voltages with the polarities for each of the blocks.

2. The voltage measuring apparatus for the battery assembly according to claim 1, further comprising:
a control unit that outputs a voltage measurement request signal to the respective voltage detection units, acquires the total voltages detected by the respective voltage detection units, and provides the acquired total voltages as the output voltages of the cells; and
a voltage conversion unit that is connected to a power supply which supplies an electric power for operating the control unit to convert the electric power from the power supply,
wherein the control unit outputs a power supply signal for supplying the electric power to the voltage conversion unit when outputting the voltage measurement request signal to the respective voltage detection units; and
wherein the voltage conversion unit supplies the electric power to the absolute value detection units upon acquiring the voltage measurement request signal from the control unit.

3. The voltage measuring apparatus for the battery assembly according to claim 1 or 2, further comprising:
a control unit that outputs a voltage measurement request signal to the respective voltage detection units, acquires the total voltages detected by the respective voltage detection units, and provides the acquired total voltages as the output voltages of the cells; and
a voltage conversion unit that is connected to a power supply which supplies an electric power for operating the control unit to convert the electric power from the power supply,
wherein the control unit outputs a power supply signal for supplying the electric power to the voltage conversion unit when outputting the voltage measurement request signal to the respective voltage detection units; and
wherein the voltage conversion unit supplies the electric power to the polarity detection units upon acquiring the voltage measurement request signal from the control unit.

4. The voltage measuring apparatus for the battery assembly according to claim 1, wherein the cells are N cells from a first cell to an N-th cell;
wherein a negative electrode of the first cell is grounded;
wherein a positive electrode of the N-th cell is set to the highest voltage; and
wherein a voltage of an n-th cell (2≤n≤N) is measured with a voltage of an (n-1)-th cell as a reference voltage.
